# EUROPEAN PATENT APPLICATION

(11) **EP 4 845 353 A1**
(43) Date of publication of application: **25.11.2026**
(21) Application number: 25189052.1
(22) Date of filing: 11.07.2025
(51) Int. Cl.: H10F 77/20, H10F 71/00

(54) **PHOTOVOLTAIC CELL, PREPARATION METHOD THEREOF AND PHOTOVOLTAIC MODULE**

(30) Priority: 23.05.2025 CN 202510673366
(71) Applicant: Zhejiang Jinko Solar Co., Ltd., Haining, Zhejiang 314416 (CN)
(72) Inventor: SHEN, Mengchao, HAINING 314416 (CN); CHEN, Xuefeng, HAINING 314416 (CN); JIANG, Chuanwei, HAINING 314416 (CN); WANG, Zhao, HAINING 314416 (CN); ZHENG, Peiting, HAINING 314416 (CN); YANG, Jie, HAINING 314416 (CN); ZHANG, Xinyu, HAINING 314416 (CN)
(74) Representative: DREISS Patentanwälte PartG mbB

(57) **Abstract**

Embodiments of the present disclosure relate to the field of photovoltaic cells, and provide a photovoltaic cell, a preparation method thereof and a photovoltaic module. The preparation method of a photovoltaic cell includes: providing a semiconductor substrate; forming an initial electrode on the semiconductor substrate using a metallization heat treatment process; and irradiating the semiconductor substrate by a charge carrier excitation source to sinter the initial electrode to form a finished electrode; wherein the irradiation of the semiconductor substrate by the charge carrier excitation source is performed at least twice; an area S of the semiconductor substrate and a power value P of the charge carrier excitation source meet the following condition: 0.048W/cm²≤P/S≤0.092W/cm². The present disclosure may at least solve the problem that high-resistance ohmic contact is formed due to a poor metallization contact effect of the electrode and the semiconductor substrate in the photovoltaic cell.

## Description

### TECHNICAL FIELD

The present disclosure relates to the field of photovoltaic cells and, in particular, to a photovoltaic cell, a preparation method thereof and a photovoltaic module.

### BACKGROUND

A photovoltaic cell is a photoelectric semiconductor sheet which directly generates electricity by utilizing sunlight, and can output a voltage and generate a current under a certain illumination condition. The photovoltaic cell structurally includes an electrode which is usually obtained by means of metallization. The electrode is in metalized contact with a semiconductor substrate, ohmic contact is formed between the electrode and the semiconductor substrate, and the formed good ohmic contact facilitates current input and output.

### SUMMARY

Embodiments of the present disclosure provide a photovoltaic cell, a preparation method thereof and a photovoltaic module, which are at least beneficial to solving the problem that high-resistance ohmic contact is formed between an electrode and a semiconductor substrate in the photovoltaic cell due to a poor metallization contact effect of the electrode and the semiconductor substrate.

In an aspect, some embodiments of the present disclosure provide a preparation method of a photovoltaic cell, including:
providing a semiconductor substrate;
forming an initial electrode on the semiconductor substrate by a metallization heat treatment process; and
irradiating the semiconductor substrate by a charge carrier excitation source to sinter the initial electrode to form a finished electrode;
wherein the irradiation of the semiconductor substrate by the charge carrier excitation source is performed at least twice; an area S of the semiconductor substrate and a power value P of the charge carrier excitation source meet the following condition: 0.048 W/cm²≤P/S≤0.092 W/cm².

In some embodiments, the power value of the charge carrier excitation source for the previous irradiation is greater than or equal to the power value of the charge carrier excitation source for the second irradiation.

In some embodiments, a ratio of the power value of the charge carrier excitation source for the previous irradiation to the power value of the charge carrier excitation source for the second irradiation ranges from 1 to 1.4.

In some embodiments, the power value of the charge carrier excitation source ranges from 10 W to 50 W.

In some embodiments, a reverse bias voltage is applied to the semiconductor substrate while the charge carrier excitation source irradiates the semiconductor substrate.

In some embodiments, a voltage value U of the reverse bias voltage and the area S of the semiconductor substrate meet the following condition: 54 mV/cm²≤U/S≤68 mV/cm².

In some embodiments, the voltage value of the reverse bias voltage during the previous irradiation of the semiconductor substrate is greater than or equal to the voltage value of the reverse bias voltage during the subsequent irradiation.

In some embodiments, a ratio of the voltage value of the reverse bias voltage during the previous irradiation of the semiconductor substrate to the voltage value of the reverse bias voltage during the subsequent irradiation ranges from 1 to 1.2.

In some embodiments, the voltage value of the reverse bias voltage is 10 V-30 V.

In some embodiments, a current is applied to the semiconductor substrate while the charge carrier excitation source irradiates the semiconductor substrate.

In some embodiments, a current value I of the current meets the following condition: 6 mA/cm²≤I/S≤15 mA/cm².

In some embodiments, the current value of the current applied during the previous irradiation to the semiconductor substrate is greater than or equal to the current value of the current applied during the subsequent irradiation to the semiconductor substrate.

In some embodiments, a ratio of the current value of the current applied during the previous irradiation to the semiconductor substrate to the current value of the current applied during the subsequent irradiation to the semiconductor substrate ranges from 1 to 1.2.

In some embodiments, the current value of the current is 2 A-7 A.

In some embodiments, the area of the semiconductor substrate is 100 cm²-600 cm².

In some embodiments, a length of the finished electrode is 5 cm-100 cm, and a width of the finished electrode is 2 µm-60 µm.

In some embodiments, a method of forming the initial electrode using the metallization heat treatment process includes:
performing screen printing treatment on the semiconductor substrate to form a paste electrode; and
performing thermal sintering treatment on the paste electrode to form the initial electrode.

In some embodiments, a sintering temperature of the thermal sintering treatment is 600 °C-880 °C, and a sintering time of the thermal sintering treatment is 30 s-120 s.

In another aspect, some embodiments of the present disclosure further provide a photovoltaic cell, wherein the photovoltaic cell is obtained using the preparation method of a photovoltaic cell according to any one of claims 1 to 18.

In some embodiments, the photovoltaic cell includes at least one of a PERC, a TOPCon cell and a BC cell.

In another aspect, some embodiments of the present disclosure further provide a photovoltaic module, including:
a solar cell string formed by connecting a plurality of photovoltaic cells;
an encapsulation adhesive film for covering a surface of the solar cell string; and
a cover plate for covering a surface of the encapsulation adhesive film away from the solar cell string;
wherein the photovoltaic cell is obtained using the preparation method of a photovoltaic cell according to any one of the above descriptions, or is the photovoltaic cell as described above.

### BRIEF DESCRIPTION OF DRAWINGS

One or more embodiments are illustrated by corresponding figures in the drawings, these illustrations do not constitute limitations on the embodiments, and unless stated otherwise, the figures in the drawings do not constitute a scale limitation. To better describe the technical solutions in the embodiments of the present disclosure or the related art, the following briefly describes the accompanying drawings required for the embodiments. Apparently, the accompanying drawings in the following description show merely some embodiments of the present disclosure, and a person of ordinary skill in the art may still derive other drawings from these accompanying drawings without creative efforts.
FIG. 1 is a flow chart of steps of a preparation method of a photovoltaic cell according to one or more embodiments of the present disclosure;
FIG. 2 is a schematic structural diagram of a semiconductor substrate in the preparation method of a photovoltaic cell according to one or more embodiments of the present disclosure;
FIG. 3 is a schematic structural diagram after a paste electrode is formed in the preparation method of a photovoltaic cell according to one or more embodiments of the present disclosure;
FIG. 4 is a schematic structural diagram after an initial electrode is formed in the preparation method of a photovoltaic cell according to one or more embodiments of the present disclosure; and
FIG. 5 is a schematic structural diagram after a finished electrode is formed in the preparation method of a photovoltaic cell according to one or more embodiments of the present disclosure.

In the drawings: 100: semiconductor substrate; 110: base; 120: dielectric layer; 130: doped layer; 210: paste electrode; 220: initial electrode; 230: finished electrode.

### DESCRIPTION OF EMBODIMENTS

As known from the background, the electrode and the semiconductor substrate are in metallization contact, ohmic contact is formed between the electrode and the semiconductor substrate, a poor metallization contact effect can increase the contact resistance between the electrode and a semiconductor, and conversely, good metallization contact can reduce the contact resistance between the electrode and the semiconductor, so that the photoelectric conversion efficiency of the photovoltaic cell is improved.

In photovoltaic cell production of the related art, a manner of bonding a conductive material to a surface of the semiconductor substrate is usually a sintering process which is a key step in an electrode preparation process, and the sintering quality of the electrode directly affects the metallization contact effect of the electrode and the semiconductor substrate. In the traditional sintering process, high temperature sintering is usually adopted and can realize solidification of a paste and formation of the electrode. However, sintering of the high-temperature furnace sintering process may cause damage to the semiconductor substrate in a non-electrode region on the one hand; on the other hand, fine control is lacked, and optimization treatment of local regions cannot be realized, which results in a non-ideal metallization contact effect of the electrode and the semiconductor substrate, thereby affecting the photoelectric conversion efficiency and stability of the photovoltaic cell.

Embodiments of the present disclosure provide a preparation method of a photovoltaic cell, which adopts the technical solution that a charge carrier excitation source is adopted to irradiate an initial electrode obtained after a metallization heat treatment process is completed. On the one hand, the charge carrier excitation source irradiates the initial electrode to cause an instantaneous high temperature to be generated on the initial electrode and a semiconductor substrate in a corresponding region, so that a material of the initial electrode and a material of the semiconductor substrate are subjected to co-fusion and diffusion, so as to improve the effect of metallization contact between a finally formed finished electrode and the semiconductor substrate, reduce the contact resistance between the finished electrode and the semiconductor substrate, and then improve the photoelectric conversion efficiency of the photovoltaic cell; on the other hand, the charge carrier excitation source can irradiate the semiconductor substrate in a non-electrode region to excite carriers while irradiating the initial electrode, so that a local current is generated to further promote a temperature rise of the initial electrode, which facilitates further co-fusion and mutual diffusion of the initial electrode and the semiconductor substrate. In the present disclosure, the charge carrier excitation source irradiates the initial electrode twice or more, which is beneficial to ensuring the sintering degree of the finished electrode and enhancing the conductivity and uniformity of the metallization contact of the finished electrode and the semiconductor substrate. In the present disclosure, the power of the charge carrier excitation source is in direct proportion to the area of the semiconductor substrate, so as to avoid that the area of the semiconductor substrate is small, but the power of the charge carrier excitation source is overlarge to cause local overheating, and excessive thermal stress is generated to damage the semiconductor substrate, or avoid that the area of the semiconductor substrate is large, but the power of the charge carrier excitation source is excessively small, so that the metalized contact effect of the finished electrode and the semiconductor substrate is poor, and contact resistance is large to reduce the photoelectric conversion efficiency of the photovoltaic cell.

In the description of embodiments of the present disclosure, technical terms "first", "second" and the like are intended only to distinguish different objects, which shall not be construed as indicating or implying a relative importance, or implicitly specifying the number, a particular order or primary and secondary relations of the indicated technical features. In the description of embodiments of the present disclosure, "a plurality of" means two or more, unless specifically stated otherwise. Similarly, "a plurality of groups" means two or more groups, and "a plurality of pieces" means two or more pieces.

The "embodiments" mentioned herein means that particular features, structures or characteristics described with reference to the embodiments may be included in one or more embodiments of the present disclosure. Phrases appearing at various positions of the specification neither always refer to the same embodiments, nor separate or alternative embodiments that are mutually exclusive with other embodiments. It is explicitly and implicitly understood by those skilled in the art that the embodiments described herein may be combined with other embodiments.

In the description of embodiments of the present disclosure, the term "and/or" is merely an association relationship describing associated objects, indicating that three relationships may exist. For example, A and/or B indicates that there are three cases of A, A and B together, and B. In addition, the character "/" herein generally means that associated objects before and after "/"are in an "or" relationship.

In the description of embodiments of the present disclosure, the orientation or position relationship indicated by the technical terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", etc. are based on the orientation or position relationship shown in the accompanying drawings and are only intended to facilitate the description of embodiments of the present disclosure and simplify the description, rather than indicating or implying that the device or element referred to must have a particular orientation or be constructed and operated in a particular orientation, and therefore are not to be interpreted as limitations on the embodiments of the present disclosure. For example, if the device or element in the drawings is turned over, elements described as "below" or "beneath" or "under" or "at the bottoms of" other elements or features would then be oriented "above" or "at the tops of" the other elements or features. Therefore, the term "below" can encompass both orientations "above" and "below" depending on the context in which the term is used, as will be apparent to one of ordinary skill in the art. Materials may be otherwise oriented (e.g., rotated by 90 degrees, turned over, flipped), and the spatially relative descriptors used herein may be interpreted accordingly.

In the description of embodiments of the present disclosure, unless specifically stated and limited, the technical terms "mounting," "coupling", "connecting" and "fixing" should be understood in a broad sense, such as, a fixed connection, a detachable connection, or an integral connection; a mechanical connection or an electrical connection; a direct connection, an indirect connection through an intermediate medium, an internal connection of two elements, or an interaction of two elements. For those of ordinary skill in the art, the specific meanings of the above terms in embodiments of the present disclosure can be understood on case-by-case.

In the drawings corresponding to embodiments of the present disclosure, the thicknesses and areas of layers are exaggerated for better understanding and ease of description. Furthermore, when a component is described as being formed "substantially" on another component, the component is not formed on the entire surface (or front surface) of the other component, nor on a partial edge of the entire surface.

In the description of embodiments of the present disclosure, when a component "includes" another component, other components are not excluded unless otherwise stated, and the other components may be further included. Forming or providing a second component over or on a first component, or forming or providing a second component on a surface of a first component, or forming or providing a second component on a side of a first component may include an embodiment in which the first component and the second component are in direct contact, and may also include an embodiment in which an additional component may be interposed between the first component and the second component, so that the first component and the second component may not be in direct contact. Various components may be arbitrarily drawn in different scales for simplicity and clarity. In the drawings, some layers/components may be omitted for simplicity. If not otherwise stated, the formation or arrangement of the second component on the surface of the first component means that the first component is in direct contact with the second component. The above-mentioned "component" may refer to a layer, a film, a region, a part, a structure, or the like.

The terminology used in the description of various described embodiments herein is for the purpose of describing particular embodiments only and is not intended to be limiting. As used in the description of the various described embodiments and the appended claims, the "component" is also intended to include the plural form unless the context clearly indicates otherwise. The component includes a layer, a film, a region, a plate, or the like.

Embodiments of the present disclosure will be described in detail below with reference to the accompanying drawings. However, it may be appreciated by those of ordinary skill in the art that in the embodiments of the present disclosure, numerous technical details are set forth in order to enable a reader to better understand the present disclosure. However, it is possible to implement the technical solution claimed by the present disclosure without these technical details and variations and modifications based on the following embodiments.

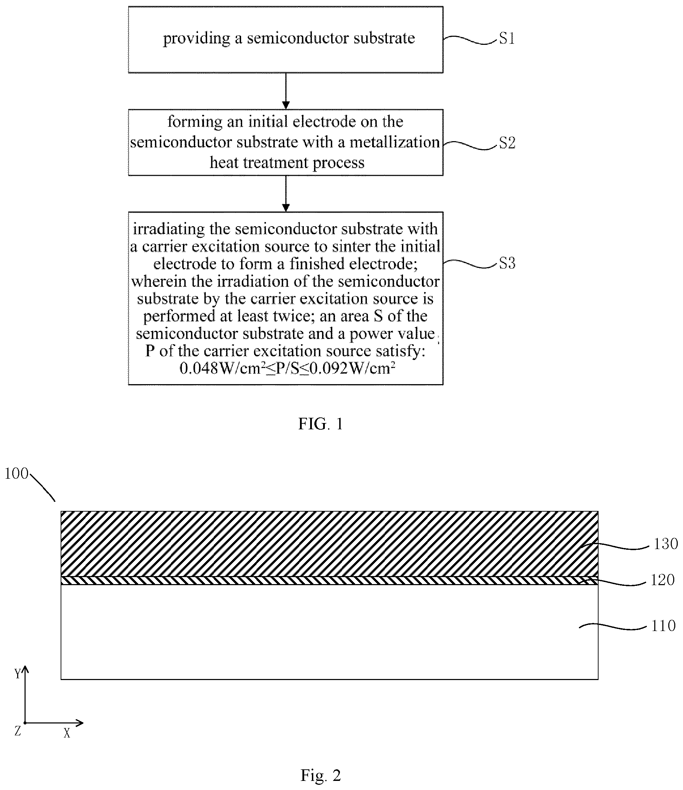

FIG. 1 is a flow chart of steps of a preparation method of a photovoltaic cell according to one or more embodiments of the present disclosure.

Referring to FIG. 1, the preparation method of a photovoltaic cell includes:
providing a semiconductor substrate 100;
forming an initial electrode 220 on the semiconductor substrate 100 using a metallization heat treatment process; and
irradiating the semiconductor substrate 100 by a charge carrier excitation source to sinter the initial electrode 220 to form a finished electrode 230;
wherein the irradiation of the semiconductor substrate 100 by the charge carrier excitation source is performed at least twice; an area S of the semiconductor substrate 100 and a power value P of the charge carrier excitation source meet the following condition: 0.048 W/cm²≤P/S≤0.092 W/cm².

In the present disclosure, the charge carrier excitation source is adopted to irradiate the semiconductor substrate 100 to carry out sintering treatment on the initial electrode 220 for several times, so as to enhance the conductivity and uniformity of the metallization contact of the finished electrode 230 and the semiconductor substrate 100, ensure the continuity of the finished electrode 230 and reduce the contact resistance. In the present disclosure, the power of the charge carrier excitation source is in direct proportion to the area of the semiconductor substrate 100, so as to reduce the risk of local overheating or a low metallization degree caused by mismatch between the power of the charge carrier excitation source and the area of the semiconductor substrate 100.

Embodiments of the present disclosure will be described in more detail below with reference to the accompanying drawings.

Referring to FIG. 1, FIG. 1 shows a flow chart of steps of a preparation method of a photovoltaic cell according to one or more embodiments of the present disclosure, including:
step S1: providing a semiconductor substrate 100. The semiconductor substrate 100 has a first direction X, a second direction Y and a third direction Z intersecting and perpendicular to one another, wherein the second direction Y is a thickness direction of the semiconductor substrate 100. The semiconductor substrate 100 has a first surface and a second surface opposite to each other in the second direction Y. For a single-sided solar cell, the first surface is a backlight surface and the second surface can be configured to receive incident light; for a double-sided solar cell, both the first and second surfaces are light-receiving surfaces and can be configured to receive incident light.

With combined reference to FIG. 2, FIG. 2 shows a schematic structural diagram of the semiconductor substrate 100 in the preparation method of a photovoltaic cell according to one or more embodiments of the present disclosure, the semiconductor substrate 100 includes a base 110, a dielectric layer 120 and a doped layer 130, which are sequentially arranged along the second direction Y, and the dielectric layer 120 and the doped layer 130 are sequentially arranged on a side of the base 110 facing the first surface.

In some embodiments, the doped layer 130 is made of at least one of doped polycrystalline silicon, doped monocrystalline silicon or doped amorphous silicon.

In some embodiments, the dielectric layer 120 is sandwiched between the base 110 and the doped layer 130, and the dielectric layer 120 may achieve a chemical passivation effect on the base 110. In addition, the dielectric layer 120 may asymmetrically shift an energy band of a first surface of the base 110, so that a potential barrier for majority carriers of carriers is lower than a potential barrier for minority carriers, and therefore, the majority carriers may easily perform quantum tunneling through the dielectric layer 120, while the minority carriers may hardly pass through the dielectric layer 120, so as to realize selective transmission of the carriers.

The dielectric layer 120 is made of at least one of silicon oxide, silicon nitride and silicon oxynitride.

Step S2: forming an initial electrode 220 on the semiconductor substrate 100 using a metallization heat treatment process.

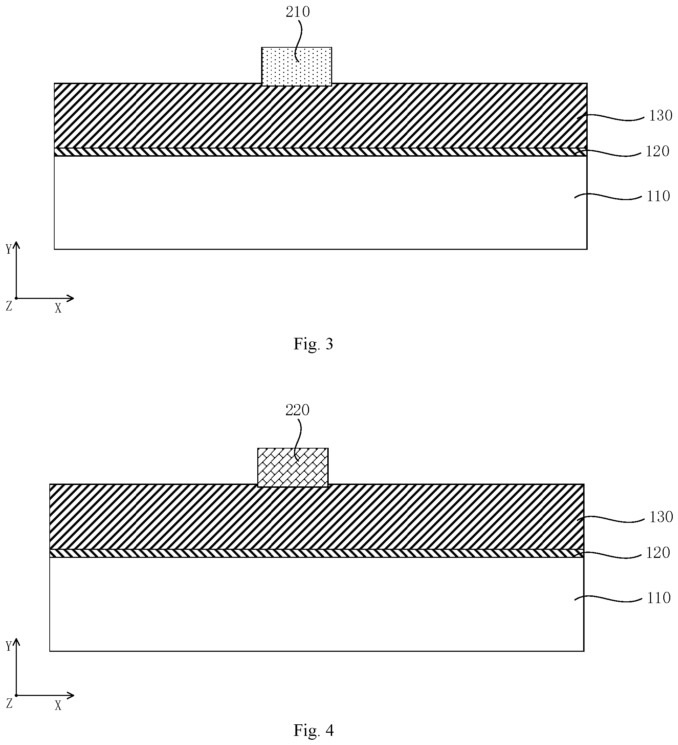

With combined reference to FIG. 3 and FIG. 4, FIG. 3 and FIG. 4 respectively show a schematic structural diagram after a paste electrode 210 is formed and a schematic structural diagram after the initial electrode 220 is formed in the preparation method of a photovoltaic cell according to one or more embodiments of the present disclosure, and a method of forming the initial electrode 220 on the semiconductor substrate 100 using the metallization heat treatment process includes:
step S21: forming the paste electrode 210 on the first surface of the semiconductor substrate 100, wherein the paste electrode 210 is formed by printing a conductive paste on the first surface of the semiconductor substrate 100.

Step S22: performing thermal sintering treatment on the paste electrode 210 to solidify the paste electrode 210 to form the initial electrode 220. At least a part of the initial electrode 220 is in metallization contact with the doped layer 130 in the semiconductor substrate 100.

In some embodiments, a method of printing the conductive paste to form the paste electrode 210 includes at least one of a screen printing process, an intaglio printing process, a letterpress printing process, a flexographic printing process, a laser transfer printing process, an ink-jet printing process, and a 3D printing process.

In some embodiments, the conductive paste may be a silver paste or an aluminum paste, or may be a silver-aluminum mixed paste.

The thermal sintering treatment refers to a traditional high-temperature sintering process in which the semiconductor substrate 100 printed with the paste electrode 210 is placed in a high-temperature environment (e.g., a sintering furnace) to realize solidification of the paste electrode 210 and formation of the initial electrode 220. Before the initial electrode 220 is irradiated by the charge carrier excitation source, the paste electrode 210 is subjected to the thermal sintering treatment to be solidified to form the initial electrode 220, so that conductive particles in the paste can be uniformly dispersed and fixed in the initial electrode 220. Although the paste electrode 210 can be solidified by the instantaneous high temperature generated when the paste electrode 210 is directly irradiated by the charge carrier excitation source, the paste electrode 210 in a paste state may have the conductive particles aggregated or separated when irradiated by the charge carrier excitation source. Therefore, in the present disclosure, the thermal sintering treatment is performed on the paste electrode 210 before the irradiation of the charge carrier excitation source, so that the paste electrode is solidified to form the initial electrode 220, thus improving the quality and the reliability of the finished electrode 230.

In some embodiments, the sintering temperature of the thermal sintering treatment is 600 °C-880 °C, and a sintering time of the thermal sintering treatment is 30s-120s.

In some embodiments, a passivation layer (not shown) is further arranged on a side surface of the doped layer 130 away from the base 110, and the paste electrode 210 or the initial electrode 220 penetrates through the passivation layer along the second direction Y and is at least partially embedded in the doped layer 130. The passivation layer has an insulation and isolation effect to protect the doped layer 130. The finished electrode 230 is formed by performing the sintering treatment on the initial electrode 220, so that the finished electrode 230 penetrates through the passivation layer and is at least partially embedded in the doped layer 130.

The passivation layer is made of at least one of silicon oxide, aluminum oxide, silicon nitride, silicon carbide and silicon oxynitride.

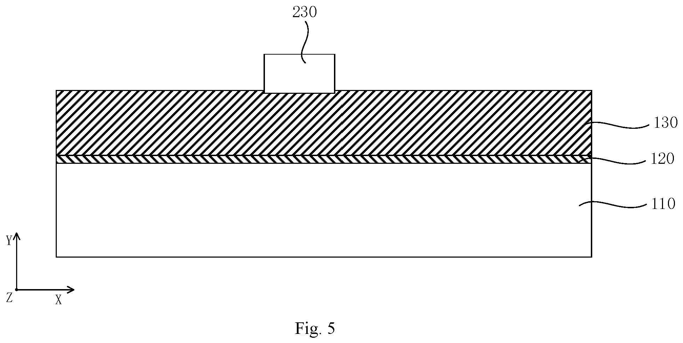

Step S3: as shown in FIG. 5 which shows a schematic structural diagram after the finished electrode 230 is formed in the preparation method of a photovoltaic cell according to one or more embodiments of the present disclosure, irradiating the semiconductor substrate 100 by the charge carrier excitation source to sinter the initial electrode 220 to form the finished electrode 230, wherein the finished electrode 230 is in metallization contact with the doped layer 130 in the semiconductor substrate 100, and compared with the metallization contact formed between the initial electrode 220 and the doped layer 130 in the previous step, the metallization contact formed between the finished electrode 230 and the doped layer 130 is greater, and the finished electrode 230 and the doped layer 130 have a better ohmic contact capability and lower contact resistance.

A method of irradiating the semiconductor substrate 100 by the charge carrier excitation source includes: irradiating the first surface of the semiconductor substrate 100 by the charge carrier excitation source to form a light spot on the first surface of the semiconductor substrate 100. The first surface of the semiconductor substrate 100 is a surface of the doped layer 130 in the semiconductor substrate 100. During movement of the charge carrier excitation source or movement in an irradiation direction of the charge carrier excitation source, a region of the initial electrode 220 on the first surface is covered by a region irradiated by the light spot formed by the irradiation of the charge carrier excitation source.

In the process that the semiconductor substrate 100 is irradiated by the charge carrier excitation source, the instantaneous high temperature is generated in the initial electrode 220 and the doped layer 130 in the region thereof, so that the material of the initial electrode 220 and the material of the doped layer 130 are subjected to co-fusion and diffusion, the metallization contact between the finished electrode 230 and the doped layer 130 is increased, and a tiny alloy junction is formed to form the finished electrode 230. Compared with the initial electrode 220, the finished electrode 230 is in greater metallization contact with the doped layer 130, good ohmic contact is formed between the finished electrode 230 and the doped layer 130, and low contact resistance is formed therebetween.

After the semiconductor substrate 100 is irradiated by the charge carrier excitation source for the first time, the semiconductor substrate 100 is irradiated by the charge carrier excitation source at least once, and after each irradiation process of the semiconductor substrate 100 by the charge carrier excitation source, the metallization contact between the finished electrode 230 and the doped layer 130 and the uniformity of the finished electrode 230 are both improved to a certain extent compared with the previous irradiation, and the contact resistance between the finished electrode 230 and the doped layer 130 is further reduced, so that the photoelectric conversion efficiency of the photovoltaic cell is improved.

In some embodiments, the shape of the light spot includes, but is not limited to, a rectangular shape, a circular shape, an elliptical shape, a linear shape (i.e., an elongated light spot), or the like. The shape of the light spot can be selected according to actual use requirements, and is not limited herein.

In some embodiments, the charge carrier excitation source is continuously moved to irradiate the semiconductor substrate 100. That is, the charge carrier excitation source is moved along a path to irradiate the semiconductor substrate 100, and the moving process and the irradiation process can be considered to be continuous.

However, the charge carrier excitation source can realize continuous work or discontinuous work by a controller, and then, the irradiation of the charge carrier excitation source can be continuous or discontinuous. In some other embodiments, the charge carrier excitation source discontinuously irradiates the semiconductor substrate 100, the moving path of the charge carrier excitation source may also be discontinuous, but the charge carrier excitation source finally irradiates a region where all the initial electrodes 220 or the finished electrodes 230 are located. The irradiation manner and the moving path of the charge carrier excitation source can be selected according to actual use requirements, and are not limited herein.

Further, the power of the charge carrier excitation source is in direct proportion to the area of the semiconductor substrate 100. In other words, the power of the charge carrier excitation source is increased in proportion to an increase in the area of the semiconductor substrate 100 or decreased in proportion to a decrease in the area of the semiconductor substrate 100. The design that the power of the charge carrier excitation source is in direct proportion to the area of the semiconductor substrate 100 avoids that the area of the semiconductor substrate 100 is small, but the power of the charge carrier excitation source is overlarge to cause local overheating, and excessive thermal stress is generated to damage the semiconductor substrate 100, or avoids that the area of the semiconductor substrate 100 is large, but the power of the charge carrier excitation source is excessively small, so that the metalized contact effect of the finished electrode 230 and the semiconductor substrate 100 is poor, and contact resistance is large to reduce the photoelectric conversion efficiency of the photovoltaic cell.

In some embodiments, the power of the charge carrier excitation source is P, the area of the semiconductor substrate 100 is S, and P and S meet the following condition: 0.048W/cm²≤P/S≤0.092W/cm². In some embodiments, 0.05W/cm²≤P/S≤0.08W/cm², and a ratio P/S between the power of the charge carrier excitation source and the area of the semiconductor substrate 100 may be 0.05W/cm², 0.06W/cm², 0.07W/cm², or 0.08W/cm².

In some embodiments, the power of the charge carrier excitation source ranges from 10W to 50W. In some embodiments, the power of the charge carrier excitation source ranges from 15W to 45W, and the power of the charge carrier excitation source can be 15W, 25W, 30W or 40W.

In some embodiments, the area of the semiconductor substrate 100 ranges from 100cm² to 600cm². In some embodiments, the area of the semiconductor substrate 100 ranges from 200cm² to 500cm², and the area of the semiconductor substrate 100 may be 200cm², 300cm², 400cm² or 500cm². The area of the semiconductor substrate 100 is set within a proper range, so that the problems of small power generation and a low photoelectric conversion efficiency of the single semiconductor substrate 100 caused by the excessively small area of the semiconductor substrate 100 or the problems of increased preparation difficulty and a low yield caused by the excessively large area of the semiconductor substrate 100 are avoided.

In order to better explain the beneficial effects of the embodiments of the present disclosure, the following provides corresponding examples and comparative examples for description, and the photovoltaic cells prepared according to the following examples and comparative examples are compared, wherein the charge carrier excitation source irradiates the semiconductor substrate 100 twice, the two powers of the charge carrier excitation source are equal, the powers of the photovoltaic cells are tested by a digital source meter apparatus under the conditions of AM1.5G simulated sunlight and 25 Celsius degrees, condition parameters not shown in the table are consistent for the examples and comparative examples, and reference is made to the following table:

**Table 1:**

| | Area S of semiconductor substrate (cm²) | Power P of charge carrier excitation source (W) | P/S (W/cm²) | Open-circuit voltage Voc (V) | Conversion efficiency Eta (%) |
|---|---|---|---|---|---|
| Example 1 | 400 | 19.2 | 0.048 | 0.7306 | 24.61 |
| Example 2 | 400 | 20 | 0.05 | 0.7311 | 24.63 |
| Example 3 | 400 | 24 | 0.06 | 0.7316 | 24.65 |
| Example 4 | 400 | 28 | 0.07 | 0.7317 | 24.65 |
| Example 5 | 400 | 32 | 0.08 | 0.7313 | 24.61 |
| Example 6 | 400 | 36.8 | 0.092 | 0.7311 | 24.60 |
| Comparative example 1 | 400 | 8 | 0.02 | 0.7232 | 24.50 |
| Comparative example 2 | 400 | 16 | 0.04 | 0.7263 | 24.55 |
| Comparative example 3 | 400 | 40 | 0.1 | 0.7271 | 24.54 |
| Comparative example 4 | 400 | 48 | 0.12 | 0.7187 | 24.49 |

As can be seen from examples 1 to 6 and comparative examples 1 to 4 in table 1, in the case where each of the semiconductor substrates 100 has an area of 400cm², the ratios P/S between the powers of the charge carrier excitation source and the areas of the semiconductor substrates 100 in examples 1 to 6 range from 0.048W/cm² to 0.092W/cm², the ratios P/S between the powers of the charge carrier excitation source and the areas of the semiconductor substrates 100 in comparative examples 1 to 4 are out of the range from 0.048W/cm² to 0.092W/cm², the open-circuit voltages and the conversion efficiencies of the photovoltaic cells in examples 1 to 6 are higher than those of comparative examples 1 to 4, and compared with comparative examples 1 to 4, in examples 1 to 6, the conversion efficiencies of the photovoltaic cells are improved by at least 0.05%. Therefore, when the ratio P/S between the power of the charge carrier excitation source and the area of the semiconductor substrate 100 is in the range from 0.048W/cm² to 0.092W/cm² in the embodiments of the present disclosure, the photoelectric conversion efficiency of the photovoltaic cell is improved.

Further, in the step of irradiating the semiconductor substrate 100 by the charge carrier excitation source a plurality of times, the power of the charge carrier excitation source previously sintering the initial electrode 220 or the finished electrode 230 is greater than or equal to the power of the charge carrier excitation source subsequently sintering the finished electrode 230. Since the charge carrier excitation source with the higher power can provide higher energy output in a shorter time and accelerate mutual fusion and diffusion between the initial electrode 220 and the doped layer 130, grains of the finished electrode 230 can be controlled more quickly to grow by the previous irradiation of the charge carrier excitation source with the higher power, so as to be more uniform and finer, thus further optimizing interface contact between the finished electrode 230 and the doped layer 130, and reducing interface defects and recombination centers. The charge carrier excitation source with the subsequent smaller power finely adjusts the formed ohmic contact, improves the sintering sufficiency of the finished electrode 230, and meanwhile improves overheating damage to the finished electrode 230, and improves the conductivity and stability of the finished electrode 230. Therefore, a process window and the adaptability of the process can be expanded.

It may be appreciated that the power of the charge carrier excitation source can be flexibly adjusted as desired for different types and sizes of initial electrodes 220 and semiconductor substrates 100. For example, for some metal electrode materials with higher melting points, sintering may be facilitated by higher powers of the charge carrier excitation source. For another example, for a fragile semiconductor substrate 100, the charge carrier excitation source with the previous higher power ensures metallization contact between the finished electrode 230 and the doped layer 130, and the charge carrier excitation source with the subsequent lower power can reduce damage to the semiconductor substrate 100. Thus, the design that the plural powers of the charge carrier excitation source are gradually reduced can improve process flexibility and adaptability.

In some embodiments, a ratio of the power of the charge carrier excitation source previously sintering the initial electrode 220 or the finished electrode 230 to the power of the charge carrier excitation source subsequently sintering the finished electrode 230 ranges from 1 to 1.4. In some embodiments, the ratio of the power of the charge carrier excitation source previously sintering the initial electrode 220 to the power of the charge carrier excitation source subsequently sintering the initial electrode 220 may be 1.02, 1.1, 1.2 or 1.3.

In order to better explain the beneficial effects of the embodiments of the present disclosure, the following provides corresponding examples and comparative examples for description, the powers of the photovoltaic cells prepared according to the following examples and comparative examples are tested by a digital source meter apparatus under the conditions of AM1.5G simulated sunlight and 25 Celsius degrees, condition parameters not shown in the table are consistent for the examples and comparative examples, and reference is made to the following table:

**Table 2:**

| | Area S of semiconductor substrate (cm²) | First-irradiation power of charge carrier excitation source P1 (W) | Second-irradiation power of charge carrier excitation source P2 (W) | P1/P2 | Open-circuit voltage Voc (V) | Conversion efficiency Eta (%) |
|---|---|---|---|---|---|---|
| Example 7 | 400 | 20 | 20 | 1 | 0.7306 | 24.61 |
| Example 8 | 400 | 20 | 19.61 | 1.02 | 0.7311 | 24.63 |
| Example 9 | 400 | 20 | 19.05 | 1.05 | 0.7316 | 24.65 |
| Example 10 | 400 | 20 | 18.18 | 1.1 | 0.7317 | 24.65 |
| Example 11 | 400 | 20 | 16.67 | 1.2 | 0.7314 | 24.62 |
| Example 12 | 400 | 20 | 14.29 | 1.4 | 0.7310 | 24.60 |
| Comparative example 5 | 400 | 20 | 21.05 | 0.95 | 0.7232 | 24.50 |
| Comparative example 6 | 400 | 20 | 22.22 | 0.9 | 0.7263 | 24.55 |
| Comparative example 7 | 400 | 20 | 13.79 | 1.45 | 0.7280 | 24.54 |
| Comparative example 8 | 400 | 20 | 13.33 | 1.5 | 0.7275 | 24.21 |

As can be seen from examples 7 to 12 and comparative examples 5 to 8 in table 2, in the case where each of the semiconductor substrates 100 has an area of 400cm² and the power of the charge carrier excitation source irradiating the semiconductor substrate 100 for the first time is 20W, a ratio between the power of the charge carrier excitation source previously sintering the initial electrode 220 or the finished electrode 230 and the power of the charge carrier excitation source subsequently sintering the finished electrode 230 in examples 7 to 12 is in the range from 1 to 1.4, the ratio between the power of the charge carrier excitation source previously sintering the initial electrode 220 or the finished electrode 230 and the power of the charge carrier excitation source subsequently sintering the finished electrode 230 in comparative examples 5 to 8 is greater than 1.4 or less than 1, the open-circuit voltages and the conversion efficiencies of the photovoltaic cells in examples 7 to 12 are higher than those of comparative examples 5 to 8, and compared with comparative examples 5 to 8, in examples 7 to 12, the conversion efficiencies of the photovoltaic cells are improved by at least 0.04%. Therefore, when the power of the charge carrier excitation source previously sintering the initial electrode 220 or the finished electrode 230 is larger than or equal to the power of the charge carrier excitation source subsequently sintering the finished electrode 230, and the ratio therebetween is in the range from 1 to 1.4, the photoelectric conversion efficiency of the photovoltaic cell is improved.

Further, while the charge carrier excitation source irradiates the semiconductor substrate 100 to sinter the initial electrode 220 or the finished electrode 230, a reverse bias voltage is applied to the semiconductor substrate 100, that is, a reverse bias voltage opposite to the polarity of a PN junction of the light-receiving surface of the semiconductor substrate 100 is applied to the semiconductor substrate 100. When the charge carrier excitation source irradiates the semiconductor substrate 100, a region of the semiconductor substrate 100 not covered by the initial electrode 220 or the finished electrode 230 is irradiated by the charge carrier excitation source to excite the carriers, and when the reverse bias voltage is applied to the semiconductor substrate 100, the excited charge carriers move directionally, thereby generating a local current. The local current may further raise the sintering temperature of the initial electrode 220 or the finished electrode 230, thereby promoting further mutual fusion and diffusion of the finished electrode 230 and the doped layer 130, and further improving the performance of the ohmic contact between the finished electrode 230 and the doped layer 130.

Further, a voltage value of the reverse bias voltage applied to the semiconductor substrate 100 is in direct proportion to the area of the semiconductor substrate 100. In other words, the voltage value of the reverse bias voltage applied to the semiconductor substrate 100 is increased in proportion to an increase in the area of the semiconductor substrate 100 or decreased in proportion to a decrease in the area of the semiconductor substrate 100. The design that the voltage value of the reverse bias voltage applied to the semiconductor substrate 100 is in direct proportion to the area of the semiconductor substrate 100 avoids that the local current is excessively large and the semiconductor substrate 100 is locally overheated due to the small area of the semiconductor substrate 100 and the excessively large voltage value of the reverse bias voltage applied to the semiconductor substrate 100, and excessive thermal stress is generated to damage the semiconductor substrate 100, or avoids that the area of the semiconductor substrate 100 is large, but the voltage value of the reverse bias voltage is excessively small, so that the metalized contact effect of the finished electrode 230 and the semiconductor substrate 100 is poor, and contact resistance is large to reduce the photoelectric conversion efficiency of the photovoltaic cell.

In some embodiments, the voltage value U of the reverse bias voltage and the area S of the semiconductor substrate 100 meet the following condition: 54mV/cm²≤U/S≤68mV/cm². In some embodiments, a ratio U/S between the voltage value of the reverse bias voltage and the area of the semiconductor substrate 100 may be 58mV/cm², 60mV/cm², 62mV/cm², or 64mV/cm².

In some embodiments, the reverse bias voltage applied to the semiconductor substrate 100 has a voltage value ranging from 10V to 30V. In some embodiments, the voltage value of the reverse bias voltage applied to the semiconductor substrate 100 may be 14V, 18V, 22V, or 26V.

In order to better explain the beneficial effects of the embodiments of the present disclosure, the following provides corresponding examples and comparative examples for description, wherein the charge carrier excitation source irradiates the semiconductor substrate 100 twice, the two powers of the charge carrier excitation source are equal, the powers of the photovoltaic cells prepared according to the following examples and comparative examples are tested by a digital source meter apparatus under the conditions of AM1.5G simulated sunlight and 25 Celsius degrees, condition parameters not shown in the table are consistent for the examples and comparative examples, and reference is made to the following table:

**Table 3:**

| | Area S of semiconductor substrate (cm²) | Reverse bias voltage U (V) | U/S (mV/cm²) | Open-circuit voltage Voc (V) | Conversion efficiency Eta (%) |
|---|---|---|---|---|---|
| Example 13 | 400 | 21.6 | 54 | 0.7306 | 24.61 |
| Example 14 | 400 | 23.2 | 58 | 0.7311 | 24.63 |
| Example 15 | 400 | 24 | 60 | 0.7316 | 24.65 |
| Example 16 | 400 | 24.8 | 62 | 0.7317 | 24.65 |
| Example 17 | 400 | 25.6 | 64 | 0.7313 | 24.61 |
| Example 18 | 400 | 27.2 | 68 | 0.7311 | 24.60 |
| Comparative example 9 | 400 | 18 | 45 | 0.7232 | 24.50 |
| Comparative example 10 | 400 | 20 | 50 | 0.7263 | 24.55 |
| Comparative example 11 | 400 | 28 | 70 | 0.7271 | 24.54 |
| Comparative example 12 | 400 | 30 | 75 | 0.7187 | 24.49 |

As can be seen from examples 13 to 18 and comparative examples 9 to 12 in table 3, in the case where each of the semiconductor substrates 100 has an area of 400cm², the ratios U/S between the voltage values of the reverse bias voltages and the areas of the semiconductor substrates 100 in examples 13 to 18 range from 54 mV/cm² to 68 mV/cm², the ratios U/S between the voltage values of the reverse bias voltages and the areas of the semiconductor substrates 100 in comparative examples 9 to 12 are out of the range from 54m V/cm² to 68 mV/cm², the open-circuit voltages and the conversion efficiencies of the photovoltaic cells in examples 13 to 18 are higher than those of comparative examples 9 to 12, and compared with comparative examples 9 to 12, in examples 13 to 18, the conversion efficiencies of the photovoltaic cells are improved by at least 0.05%. Thus, when the ratio U/S between the voltage value of the reverse bias voltage applied to the semiconductor substrate 100 when the charge carrier excitation source irradiates the semiconductor substrate 100 and the area of the semiconductor substrate 100 is within the range from 54 mV/cm² to 68 mV/cm² in the embodiments of the present disclosure, the photoelectric conversion efficiency of the photovoltaic cell is improved.

Further, the voltage value of the reverse bias voltage during the previous irradiation of the semiconductor substrate 100 is greater than or equal to the voltage value of the reverse bias voltage during the subsequent irradiation 100. Since the larger reverse bias voltage can enhance the transmission capability of the carriers and is beneficial to mutual fusion and diffusion between the finished electrode 230 and the doped layer 130 to form good ohmic contact, the reverse bias voltage with a larger voltage value applied for the first time or previously can enhance electric field strength, promote an accelerated motion of the carriers between the finished electrode 230 and the semiconductor substrate 100 to more effectively break the potential barrier at the interface, and promote the mutual diffusion between the finished electrode 230 and the doped layer 130, thereby forming better ohmic contact. The subsequent reverse bias voltage with the lower voltage value may not only finely adjust the formed ohmic contact to further optimize the stability of the contact interface, but also control further growth of the metal grains to further optimize the conductivity and uniformity of the metallization contact of the finished electrode 230 and the semiconductor substrate 100.

In some embodiments, a ratio between the voltage value of the reverse bias voltage during the previous irradiation of the semiconductor substrate 100 and the voltage value of the reverse bias voltage during the subsequent irradiation 100 ranges from 1 to 1.2. In some embodiments, the ratio between the voltage value of the reverse bias voltage during the previous irradiation of the semiconductor substrate 100 and the voltage value of the reverse bias voltage during the subsequent irradiation 100 may be 1.02, 1.05, 1.1, or 1.15.

In order to better explain the beneficial effects of the embodiments of the present disclosure, the following provides corresponding examples and comparative examples for description, wherein the charge carrier excitation source irradiates the semiconductor substrate 100 twice, the two powers of the charge carrier excitation source are 25W, the powers of the photovoltaic cells prepared according to the following examples and comparative examples are tested by a digital source meter apparatus under the conditions of AM1.5G simulated sunlight and 25 Celsius degrees, condition parameters not shown in the table are consistent for the examples and comparative examples, and reference is made to the following table:

**Table 4:**

| | Area S of semiconductor substrate (cm²) | Reverse bias voltage applied for the first time U1 (V) | Reverse bias voltage applied for the second time U2 (V) | U1/U2 | Open-circuit voltage Voc (V) | Conversion efficiency Eta (%) |
|---|---|---|---|---|---|---|
| Example 19 | 400 | 25 | 25 | 1 | 0.7306 | 24.61 |
| Example 20 | 400 | 25 | 24.5 | 1.02 | 0.7311 | 24.63 |
| Example 21 | 400 | 25 | 23.81 | 1.05 | 0.7316 | 24.65 |
| Example 22 | 400 | 25 | 22.73 | 1.1 | 0.7317 | 24.65 |
| Example 23 | 400 | 25 | 21.74 | 1.15 | 0.7314 | 24.62 |
| Example 24 | 400 | 25 | 20.83 | 1.2 | 0.7310 | 24.60 |
| Comparative example 13 | 400 | 25 | 26.32 | 0.95 | 0.7232 | 24.50 |
| Comparative example 14 | 400 | 25 | 27.78 | 0.9 | 0.7263 | 24.55 |
| Comparative example 15 | 400 | 25 | 20 | 1.25 | 0.7280 | 24.54 |
| Comparative example 16 | 400 | 25 | 19.23 | 1.3 | 0.7275 | 24.21 |

As can be seen from examples 19 to 24 and comparative examples 13 to 16 in table 4, in the case where each of the semiconductor substrates 100 has an area of 400cm² and each of the voltage values of the reverse bias voltages applied for the first time is 25V, the ratio between the voltage value of the reverse bias voltage during the previous irradiation of the semiconductor substrate 100 and the voltage value of the reverse bias voltage during the subsequent irradiation 100 in examples 19 to 24 is in the range from 1 to 1.2, the ratio between the voltage value of the reverse bias voltage during the previous irradiation of the semiconductor substrate 100 and the voltage value of the reverse bias voltage during the subsequent irradiation 100 in comparative examples 13 to 16 is less than 1 or larger than 1.2, the open-circuit voltages and the conversion efficiencies of the photovoltaic cells in examples 19 to 24 are higher than those of comparative examples 13 to 16, and compared with comparative examples 13 to 16, in examples 19 to 24, the conversion efficiencies of the photovoltaic cells are improved by at least 0.04%. Therefore, when the voltage value of the reverse bias voltage during the previous irradiation of the semiconductor substrate 100 is greater than or equal to the voltage value of the reverse bias voltage during the subsequent irradiation 100, and the ratio therebetween ranges from 1 to 1.2, the photoelectric conversion efficiency of the photovoltaic cell is improved.

Further, while the charge carrier excitation source irradiates the semiconductor substrate 100 to sinter the initial electrode 220 or the finished electrode 230, a current is applied to the semiconductor substrate 100. When the semiconductor substrate 100 is irradiated by the charge carrier excitation source, the region of the semiconductor substrate 100 not covered by the initial electrode 220 or the finished electrode 230 is irradiated by the charge carrier excitation source to excite carriers, and when the current is applied to the semiconductor substrate 100, the excited charge carriers move directionally, which is beneficial to exciting electron-hole pairs, optimizing electric field distribution of the semiconductor substrate 100, promoting formation of the metal grains in the finished electrode 230, and improving metallization structures of the finished electrode 230 and the doped layer 130, thereby reducing the contact resistance between the finished electrode 230 and the doped layer 130, and further improving the photoelectric conversion efficiency of the photovoltaic cell.

Further, a current value of the current applied to the semiconductor substrate 100 is in direct proportion to the area of the semiconductor substrate 100. In other words, the current value of the current applied to the semiconductor substrate 100 is increased in proportion to an increase in the area of the semiconductor substrate 100 or decreased in proportion to a decrease in the area of the semiconductor substrate 100. The design that the current value of the current applied to the semiconductor substrate 100 is in direct proportion to the area of the semiconductor substrate 100 avoids that the semiconductor substrate 100 is locally overheated due to the small area of the semiconductor substrate 100 and the excessively large current value of the current applied to the semiconductor substrate 100, and excessive thermal stress is generated to damage the finished electrode 230 and the semiconductor substrate 100, or avoids that the area of the semiconductor substrate 100 is large, but the current value of the current is excessively small, so that the metalized contact effect of the finished electrode 230 and the semiconductor substrate 100 is poor, and contact resistance is large to reduce the photoelectric conversion efficiency of the photovoltaic cell.

In some embodiments, the current value I of the current and the area S of the semiconductor substrate 100 meet the following condition: 6mA/cm²≤I/S≤15mA/cm². In some embodiments, 8mA/cm²≤I/S≤14mA/cm², and the ratio I/S between the current value of the current and the area of the semiconductor substrate 100 may be 8mA/cm², 10mA/cm², 12mA/cm², or 14mA/cm².

In some embodiments, the current applied to the semiconductor substrate 100 has a current value ranging from 2A to 7A. In some embodiments, the current value of the current applied to the semiconductor substrate 100 may be 3A, 4A, 5A, or 6A.

In order to better explain the beneficial effects of the embodiments of the present disclosure, the following provides corresponding examples and comparative examples for description, wherein the charge carrier excitation source irradiates the semiconductor substrate 100 twice, the two powers of the charge carrier excitation source are equal, the powers of the photovoltaic cells prepared according to the following examples and comparative examples are tested by a digital source meter apparatus under the conditions of AM1.5G simulated sunlight and 25 Celsius degrees, condition parameters not shown in the table are consistent for the examples and comparative examples, and reference is made to the following table:

**Table 5:**

| | Area S of semiconductor substrate (cm²) | Current value I (A) | I/S (mA/cm²) | Open-circuit voltage Voc (V) | Conversion efficiency Eta (%) |
|---|---|---|---|---|---|
| Example 25 | 400 | 2.4 | 6 | 0.7306 | 24.61 |
| Example 26 | 400 | 3.2 | 8 | 0.7311 | 24.63 |
| Example 27 | 400 | 4 | 10 | 0.7316 | 24.65 |
| Example 28 | 400 | 4.8 | 12 | 0.7317 | 24.65 |
| Example 29 | 400 | 5.6 | 14 | 0.7313 | 24.61 |
| Example 30 | 400 | 6 | 15 | 0.7311 | 24.60 |
| Comparative example 17 | 400 | 1.6 | 4 | 0.7232 | 24.50 |
| Comparative example 18 | 400 | 2 | 5 | 0.7263 | 24.55 |
| Comparative example 19 | 400 | 6.4 | 16 | 0.7271 | 24.54 |
| Comparative example 20 | 400 | 6.8 | 17 | 0.7187 | 24.49 |

As can be seen from examples 25 to 30 and comparative examples 17 to 20 in table 5, in the case where each of the semiconductor substrates 100 has an area of 400cm², the ratio I/S between the current value of the current applied to the semiconductor substrate 100 and the area of the semiconductor substrate 100 in examples 25 to 30 range from 6mA/cm² to 15mA/cm², the ratio I/S between the current value of the current applied to the semiconductor substrate 100 and the area of the semiconductor substrate 100 in comparative examples 17 to 20 are out of the range from 6mA/cm² to 15mA/cm², and the open-circuit voltages and the conversion efficiencies of the photovoltaic cells in examples 25 to 30 are higher than those of comparative examples 17 to 20. Compared with comparative examples 17 to 20, in examples 25 to 30, the conversion efficiencies of the photovoltaic cells are improved by at least 0.05% Thus, when the ratio I/S between the current value of the current applied to the semiconductor substrate 100 when the charge carrier excitation source irradiates the semiconductor substrate 100 and the area of the semiconductor substrate 100 is within the range from 6mA/cm² to 15mA/cm², the photoelectric conversion efficiency of the photovoltaic cell is improved.

Further, the current value of the current applied during the previous irradiation to the semiconductor substrate 100 is greater than or equal to the current value of the current applied during the subsequent irradiation to the semiconductor substrate 100. The first or previous application of a current with a larger current value to the semiconductor substrate 100 is beneficial to exciting electron-hole pairs and optimizing the electric field distribution of the semiconductor substrate 100. The subsequent applied current with a small current value finely adjusts the electric field distribution of the semiconductor substrate 100, improves the uniformity and stability of the metallization contact between the finished electrode 230 and the semiconductor substrate 100, and then improves the reliability of the photovoltaic cell.

In some embodiments, a ratio between the current value of the current applied during the previous irradiation to the semiconductor substrate 100 and the current value of the current applied during the subsequent irradiation to the semiconductor substrate 100 ranges from 1 to 1.2. In some embodiments, the ratio between the current value of the current applied during the previous irradiation to the semiconductor substrate 100 and the current value of the current applied during the subsequent irradiation to the semiconductor substrate 100 may be 1.02, 1.05, 1.1, or 1.15.

In order to better explain the beneficial effects of the embodiments of the present disclosure, the following provides corresponding examples and comparative examples for description, wherein the charge carrier excitation source irradiates the semiconductor substrate 100 twice, the two powers of the charge carrier excitation source are 25W, the powers of the photovoltaic cells prepared according to the following examples and comparative examples are tested by a digital source meter apparatus under the conditions of AM1.5G simulated sunlight and 25 Celsius degrees, condition parameters not shown in the table are consistent for the examples and comparative examples, and reference is made to the following table: **[00120]**

**Table 6:**

| | Area S of semiconductor substrate (cm²) | Current applied for the first time I1 (A) | Current applied for the second time I2 (A) | I1/I2 | Open-circuit voltage Voc (V) | Conversion efficiency Eta (%) |
|---|---|---|---|---|---|---|
| Example 31 | 400 | 4 | 4 | 1 | 0.7306 | 24.61 |
| Example 32 | 400 | 4 | 3.92 | 1.02 | 0.7311 | 24.63 |
| Example 33 | 400 | 4 | 3.81 | 1.05 | 0.7316 | 24.65 |
| Example 34 | 400 | 4 | 3.64 | 1.1 | 0.7317 | 24.65 |
| Example 35 | 400 | 4 | 3.48 | 1.15 | 0.7314 | 24.62 |
| Example 36 | 400 | 4 | 3.33 | 1.2 | 0.7310 | 24.60 |
| Comparative example 21 | 400 | 4 | 4.21 | 0.95 | 0.7232 | 24.50 |
| Comparative example 22 | 400 | 4 | 4.44 | 0.9 | 0.7263 | 24.55 |
| Comparative example 23 | 400 | 4 | 3.20 | 1.25 | 0.7280 | 24.54 |
| Comparative example 24 | 400 | 4 | 3.08 | 1.3 | 0.7275 | 24.21 |

As can be seen from examples 31 to 36 and comparative examples 21 to 24 in table 6, in the case where each of the semiconductor substrates 100 has an area of 400cm² and each of the current values of the currents applied for the first time is 4A, the ratio between the current value of the current applied during the previous irradiation to the semiconductor substrate 100 and the current value of the current applied during the subsequent irradiation to the semiconductor substrate 100 in examples 31 to 36 is in the range from 1 to 1.2, the ratio between the current value of the current applied during the previous irradiation to the semiconductor substrate 100 and the current value of the current applied during the subsequent irradiation to the semiconductor substrate 100 in comparative examples 21 to 24 is less than 1 or larger than 1.2, the open-circuit voltages and the conversion efficiencies of the photovoltaic cells in examples 31 to 36 are higher than those of comparative examples 21 to 24, and compared with comparative examples 21 to 24, in examples 31 to 36, the conversion efficiencies of the photovoltaic cells are improved by at least 0.04%. Therefore, when the current value of the current applied during the previous irradiation to the semiconductor substrate 100 is greater than or equal to the current value of the current applied during the subsequent irradiation to the semiconductor substrate 100, and the ratio therebetween is in the range from 1 to 1.2, the photoelectric conversion efficiency of the photovoltaic cell is improved.

In some embodiments, the finished electrode 230 has a length in the range from 5cm to 100cm. In some embodiments, the length of the finished electrode 230 may be selected to be 10cm, 20cm, 30cm, 40cm, 50cm, 60cm, 70cm, 80cm, or 90cm. In some embodiments, the width of the finished electrode 230 ranges from 2µm to 60µm. In some embodiments, the width of the finished electrode 230 may be selected to be 10µm, 20µm, 30µm, 40µm, or 50µm. A properly sized finished electrode 230 cannot be fused due to an excessively small size or sintered incompletely due to an excessively large size during formation thereof.

In some embodiments, a carrier of the irradiation of the semiconductor substrate 100 by the charge carrier excitation source is a laser, the laser can be red light, infrared light, violet light, ultraviolet light, green light, blue light or other lasers, and the lasers not only have higher energy, but also are easy to obtain and have lower costs.

It should be understood that the laser is generated in the manner that electrons in atoms are excited by external energy to transit from a low level to a high level and then fall back from the high level to the low level to release photons. All the photons move synchronously with the same wavelength and phase, thus forming the laser. An apparatus of the charge carrier excitation source, namely an apparatus for forming the laser, includes a pumping source, a gain medium and a resonant cavity. The pumping source provides excitation energy to increase the low level of the electrons to the high level; the gain medium generates the laser; the resonant cavity is made up of two mirrors with specific geometries and reflection characteristics to ensure that the photons are reflected plural times within the cavity, so as to amplify the laser.

It should be noted that one or more carrier lasers may be used to irradiate the semiconductor substrate 100 by the charge carrier excitation source multiple times. For example, when plural carrier lasers are used to irradiate the semiconductor substrate 100 by the charge carrier excitation source multiple times, the carrier laser for the previous irradiation by the charge carrier excitation source is a blue laser with higher energy, and the carrier laser for the subsequent irradiation by the charge carrier excitation source is a red laser with lower energy. Correspondingly, one or more apparatuses of the charge carrier excitation source may be used to irradiate the semiconductor substrate 100 by the charge carrier excitation source multiple times. Therefore, the carrier laser and the apparatus of the charge carrier excitation source can be flexibly selected according to actual requirements, and the process flexibility and adaptability of the preparation method of a photovoltaic cell according to the present disclosure are improved.

In another aspect, some embodiments of the present disclosure further provide a photovoltaic cell, which is prepared using the preparation method of a photovoltaic cell according to the foregoing embodiments. It should be noted that the same or corresponding parts as those in the previous embodiments are not repeated herein.

It should be noted that the photovoltaic cell may be a monolithic solar cell or a segmented solar cell, and a segmented solar cell refers to a solar cell formed by cutting a complete monolithic solar cell.

In some embodiments, the photovoltaic cell includes, but is not limited to, one or any combination of solar cells with metallization contact between the metal electrodes and the semiconductor structures, such as a passivated emitter rear cell (PERC), a tunnel oxide passivated contact (TOPCon) cell, and a back contact (BC) cell.

In another aspect, some embodiments of the present disclosure further provide a photovoltaic module for converting received light energy into electric energy. It should be noted that the same or corresponding parts as those in the previous embodiments are not repeated herein.

The photovoltaic module includes: a solar cell string formed by connecting a plurality of photovoltaic cells formed using the preparation method of a solar cell according to the foregoing embodiments or by connecting a plurality of photovoltaic cells according to the foregoing embodiments; a encapsulation adhesive film for covering a surface of the solar cell string; and a cover plate for covering a surface of the encapsulation adhesive film away from the solar cell string. The solar cells are electrically connected in a monolithic or plural-segment form to form the plurality of solar cell strings, and the plurality of solar cell strings are electrically connected in series and/or in parallel.

The encapsulation adhesive film may be an organic encapsulation adhesive film, such as an ethylene-vinyl acetate (EVA) adhesive film, a polyolyaltha olfin (POE) adhesive film, or a polyvinyl butyral (PVB) adhesive film.

The cover plate may be a glass cover plate, a plastic cover plate, or the like, having a light transmitting function. In some embodiments, a surface of the cover plate facing the adhesive film may be a concave-convex surface, so as to increase the utilization rate of incident light.

## Claims

1. A method for preparing a photovoltaic cell, comprising:
providing a semiconductor substrate;
forming an initial electrode on the semiconductor substrate by a metallization heat treatment process; and
irradiating the semiconductor substrate with a charge carrier excitation source to sinter the initial electrode to form a finished electrode;
wherein the irradiation of the semiconductor substrate by the charge carrier excitation source is performed at least twice; and an area S of the semiconductor substrate and a power value P of the charge carrier excitation source satisfy: 0.048W/cm²≤P/S≤0.092W/cm².

2. The method according to claim 1, wherein a power value of the charge carrier excitation source for a previous irradiation in the at least two irradiation is greater than or equal to a power value for a subsequent irradiation in the at least two irradiation;
wherein a ratio of the power value of the charge carrier excitation source for the previous irradiation to the power value of the charge carrier excitation source for the subsequent irradiation ranges from 1 to 1.4.

3. The method according to claim 1, wherein the power value of the charge carrier excitation source ranges from 10 W to 50 W.

4. The method according to claim 1, wherein a reverse bias voltage is applied to the semiconductor substrate during the irradiation by the charge carrier excitation source;
wherein a voltage value U of the reverse bias voltage and the area S of the semiconductor substrate satisfy: 54 mV/cm²≤U/S≤68 mV/cm².

5. The method according to claim 4, wherein a voltage value of the reverse bias voltage applied during a previous irradiation of the semiconductor substrate is greater than or equal to a voltage value of the reverse bias voltage applied during a subsequent irradiation;
wherein a ratio of the voltage value of the reverse bias voltage during the previous irradiation of the semiconductor substrate to the voltage value of the reverse bias voltage during the subsequent irradiation ranges from 1 to 1.2;
wherein the voltage value of the reverse bias voltage is 10 V-30 V.

6. The method according to claim 1, wherein a current is applied to the semiconductor substrate during the irradiation by the charge carrier excitation source;
wherein a current value I of the current satisfies: 6mA/cm²≤I/S≤15mA/cm².

7. The method according to claim 6, wherein the current value of the current applied during a previous irradiation to the semiconductor substrate is greater than or equal to the current value of the current applied during a subsequent irradiation to the semiconductor substrate.

8. The method according to claim 7, wherein a ratio of the current value of the current applied during the previous irradiation to the semiconductor substrate to the current value of the current applied during the subsequent irradiation to the semiconductor substrate ranges from 1 to 1.2.

9. The method according to claim 6, wherein the current value of the current ranges from 2 A to 7 A.

10. The method according to claim 1, wherein an area of the semiconductor substrate ranges from 100 cm² to 600 cm².

11. The method according to claim 1, wherein a length of the finished electrode ranges from 5 cm to100 cm, and a width of the finished electrode ranges from 2 µm to 60 µm.

12. The method according to claim 1, wherein the forming the initial electrode on the semiconductor substrate by the metallization heat treatment process comprises:
performing screen printing on the semiconductor substrate to form a paste electrode; and
performing thermal sintering to the paste electrode to form the initial electrode.

13. The method according to claim 12, wherein a sintering temperature of the thermal sintering ranges from 600°C to 880°C, and sintering time of the thermal sintering ranges from 30 s to 120 s.

14. A photovoltaic cell prepared by the method according to claim 1.

15. A photovoltaic module, comprising:
a solar cell string formed by connecting photovoltaic cells;
an encapsulation adhesive film for covering a surface of the solar cell string; and
a cover plate for covering a surface of the encapsulation adhesive film facing away from the solar cell string;
wherein one photovoltaic cell of the photovoltaic cells is prepared by the method according to claim 1.
